(19) Europäisches Patentamt
European Patent Office
Office européen des brevets

(11) EP 1 592 131 B1

(12) **EUROPÄISCHE PATENTSCHRIFT**

(45) Veröffentlichungstag und Bekanntmachung des Hinweises auf die Patenterteilung:
**27.06.2007 Patentblatt 2007/26**

(51) Int Cl.:
**H03H 17/02** *(2006.01)*     **G01R 23/173** *(2006.01)*

(21) Anmeldenummer: **05006952.5**

(22) Anmeldetag: **30.03.2005**

(54) **Spektrumanalysator mit hoher Geschwindigkeit und gleichzeitig hoher Auflösung**

Spectrum analyzer having high speed as well as high resolution

Analyseur de spectre présentant simultanément une vitesse élevée et une haute résolution

(84) Benannte Vertragsstaaten:
**DE FR GB**

(30) Priorität: **26.04.2004 DE 102004020278**

(43) Veröffentlichungstag der Anmeldung:
**02.11.2005 Patentblatt 2005/44**

(60) Teilanmeldung:
**07004367.4 / 1 788 399**

(73) Patentinhaber: **Rohde & Schwarz GmbH & Co. KG**
**81671 München (DE)**

(72) Erfinder: **Wanierke, Otmar**
**81539 München (DE)**

(74) Vertreter: **Körfer, Thomas et al**
**Mitscherlich & Partner**
**Patent- und Rechtsanwälte**
**Sonnenstrasse 33**
**80331 München (DE)**

(56) Entgegenhaltungen:
DE-A1- 10 105 258     US-A- 5 300 878
US-A1- 2003 146 743     US-B1- 6 275 020
US-B1- 6 445 327

Bemerkungen:
Die Akte enthält technische Angaben, die nach dem Eingang der Anmeldung eingereicht wurden und die nicht in dieser Patentschrift enthalten sind.

**Beschreibung**

Die Erfindung betrifft einen Spektrumanalysator mit hoher Geschwindigkeit und gleichzeitig hoher Auflösung.

Spektrumanalysatoren mit hoher Geschwindigkeit und gleichzeitig hoher Auflösung wenden nach Christoph Rauscher: "Grundlagen der Spektrumsanalyse ", Rohde und Schwarz GmbH & Co. KG, München, 2000, Seite 19 bis 28, vielfach das Verfahren der FFT-Analyse (Fast Fourier Transformation) an. Aufgrund der notwendigen AnalogDigital-Wandelung des Meßsignals für die Durchführung der FFT-Analyse ist die Bandbreite des zu analysierenden Eingangsfrequenzbereich durch die maximale Abtastfrequenz der eingesetzten Analog-Digital-Wandler auf eine maximale Bandbreite $B_{MAX}$ eingeschränkt (Nyquist-Kriterium). Man ist in einem solchen Fall gezwungen, den gesamten Eingangsfrequenzbereich in mehrere Teilfrequenzbereiche zu unterteilen, die nacheinander jeweils über einen Mischer in einen Frequenzbereich umgesetzt werden, dessen Bandbreite innerhalb der maximalen Bandbreite $B_{MAX}$ des Analog-Digital-Wandlers liegt. Nachteilig an dieser sequenziellen Durchführung der FFT-Analyse der einzelnen Teilfrequenzbänder ist die endliche Einschwinggeschwindigkeit des Mischers auf die für die Frequenzumsetzung der einzelnen Teilfrequenzbänder erforderlichen Mischerfrequenzen. Um die einzelnen Teilfrequenzbänder mit einer bestimmten Frequenzgenauigkeit $B_A$ im Rahmen der Spektrumanalyse zu analysieren, entstehen Wartezeiten zwischen den Vermessungen zweier benachbarter Teilfrequenzbänder. Diese Wartezeit erhöht sich bei höherer Frequenzauflösung $B_A$ der Spektrumsanalyse.

Derartige Wartezeiten entfallen bei einem Spektrumanalysator nach dem Überlagerungsprinzip, wie er aus Christoph Rauscher: " Grundlagen der Spektrumsanalyse", Rohde und Schwarz GmbH & Co. KG, München, 2000, Seite 29 bis 32, bekannt ist. Hierbei wird ein Meßsignal mit Hilfe eines Mischers und eines Lokaloszillators (LO) auf eine Zwischenfrequenz umgesetzt. Ist die Frequenz des Lokaloszillators abstimmbar, so kann durch Variation der LO-Frequenz der gesamte Eingangsfrequenzbereich auf eine konstante Zwischenfrequenz umgesetzt werden. Auf diese Weise ist es möglich, den gesamten Eingangsfrequenzbereich durch ein Auflösungsfilter (Resolutions-Filter) mit einer vorgegebenen Bandbreite, dessen Mittenfrequenz exakt auf der konstanten Zwischenfrequenz liegt, zu fahren (sweepen). Das Abstimmen der Mischerfrequenz erfolgt nicht sprunghaft wie beim Verfahren der FFT-Analyse, sondern kontinuierlich entlang einer Rampe mit einer konstanten Sweep-Geschwindigkeit $V_s$. Zum Durchstimmen des Eingangsfrequenzbereiches benötigt der Spektrumanalysator nach dem Überlagerungsprinzip folglich eine Sweepzeit $t_s$, während Einschwingzeiten des Mischers entfallen.

Bei geforderter Auflösebandbreite $B_A$ ist die in einem Spektrumanalysator nach den Überlagerungsprinzip realisierbare Sweepgeschwindigkeit $v_s$ begrenzt, da sich beide Größen gegenseitig eingrenzen. Zwischen der geforderten Auflösebandbreite $B_A$ und der realisierbaren Sweepgeschwindigkeit $v_s$ besteht ein quadratischer Zusammenhang, der durch den inversen K-Faktor als Proportionalitätsfaktor beschrieben ist. Während bei analogen Auflösungsfiltern lediglich K-Faktoren, die größer als 2,5 sind, realisierbar sind, sind bei digitalen Auflösungsfiltern, wie in der DE 101 05 258 A1 gezeigt ist, kleinere K-Faktoren möglich.

Da die zeitdiskrete Impulsantwort des Auflösungsfilters der DE 101 05 258 A1 einen komplexen Term ($\exp(-jC_3 * t^2)$) aufweist, entstehen, falls das Auflösungsfilter von einem Meßsignal mit einem charakteristischen Frequenzspektrum angeregt wird, Schwingungen. Diese Schwingungen müssen durch den Dämpfungsterm ($\exp(C_2 * t^2)$) der zeitdiskreten Impulsantwort des Auflösungfilters effizient gedämpft werden. Da die Dämpfungskonstante C2 des Dämpfungsterms ($C2 = \pi^2 * B_{RES}^2/(2+\ln(2))$) indirekt proportional zum Quadrat der Bandbreite $B_{RES}$ des Auflösungsfilters ist, muss das Auflösungsfilter im Hinblick auf eine effiziente Dämpfung von auftretenden Schwingungen möglichst breitbandig ausgelegt werden, wodurch sich die Auflösung des Spektrumanalysators deutlich verschlechtert.

US 2003/0146743 offenbart einen Spektrumanalysator mit einem Zwischenfrequenz-Verarbeitungsschaltkreis, der ein Auflösungsbandbreite-Filter aufweist.

US 6 275 020 B offenbart in Figur 10 einen Spektrumanalysator mit einem schmalbandigen Auflösungsfilter.

US 5,300,878 offenbart einen Spektrumanalysator mit einem Zwischenfrequenzfilter und zwei Tiefpass-Filtern.

Der Erfindung liegt deshalb die Aufgabe zugrunde, einen Spektrumanalysator nach den Überlagerungsprinzip derart weiterzuentwickeln, dass einerseits die Bandbreite $B_{RES}$ des Auflösungfilters im Hinblick auf eine hohe Auflösung des Spektrumanalysators möglichst optimiert ist und gleichzeitig bei maximal realisierter Auflösung $B_A$ des Auflösungsfilters eine möglichst hohe Sweepgeschwindigkeit $V_s$ verwirklicht wird.

Die Aufgabe der Erfindung wird durch einen Spektrumanalysator mit den Merkmalen des Anspruchs 1 gelöst.

Das Auflösungsfilter des erfindungsgemäßen Spektrumanalysators besteht aus einer Serienschaltung eines Vorfilters und eines Korrelators. Während das Vorfilter eine von der Sweepgeschwindigkeit $v_s$ des Spektrumanalysator unabhängige Impulsantwort h(t) aufweist, ist der Korrelator durch eine Korrekturfunktion g(t) gekennzeichnet, die eine Abhängigkeit von der Sweepgeschwindigkeit $v_s$ des Spektrumanalysators besitzt. Mit der Korrekturfunktion g(t) wird im Korrelator das im Vorfilter vorgefilterte Eingangsignal a(t) am Eingang des Spektrumanalysators gefaltet.

Wie noch gezeigt wird, korrigiert der Korrelator mit seiner Korrekturfunktion g(t) den Einfluss der "Frequenzrampe" der Mischerfrequenz in Übertragungsverhalten des Spektrumanalysators.

Zusätzlich, wie auch noch gezeigt wird, bewirkt die Faltung des im Vorfilter vorgefilterten Eingangsignals a(t) im Auflösungsfilter des erfindungsgemäßen Spektrumanalysators ein Übertragungsverhalten des Auflösungsfilters, dass durch eine reelle Impulsantwort h(t) beschrieben wird. Auf diese Weise werden im Auflösungsfilter keine Schwingungen angeregt.

Schließlich kann durch die erfindungsgemäße Konstellation der Serienschaltung des Vorfilters und des Korrelators des Auflösungsfilters des erfindungsgemäßen Spektrumanalysators, wie auch noch gezeigt wird, die Gegenläufigkeit des Einflusses der Auflösungsbandbreite $B_A$ des Auflösungsfilters und der Sweepgeschwindigkeit $v_s$ des erfindungsgemäßen Spektrumanalysators aufgehoben werden. Somit ist ein minimaler K-Faktor gar nicht mehr anzustreben und der K-Faktor verliert bei einem derart realisierten Auflösungsfilter vollkommen seine Bedeutung bei der Optimierung der Auflösungsbandbreite $B_A$ und der Sweep-Geschwindigkeit $v_s$. Anzustreben ist vielmehr, die Auflösungsbandreite $B_A$ des Auflösungsfilter möglichst breitbandig zu gestalten, was durch die Abtastrate des integrierten Analog-Digital-Wandlers und der maximal realisierbaren Bandbreite $B_{RES}$ des analogen Vorfilters begrenzt ist.

Vorteilhafte Ausgestaltungen der Erfindung sind in den abhängigen Ansprüchen angegeben.

Im Hinblick auf eine höhere Digitalisierung des Auflösungfilters und der damit verbundenen Vorteile - z.B. höherer Signal-Rausch-Abstand, vereinfachter Aufbau durch höhere Integration - ist das Auflösungsfilter des Spektrumanalysators in eine analoge Komponente zur analogen Vorfilterung im Zwischenfrequenzbereich und eine digitale Komponente mit nicht-rekursiver Filterstruktur (FIR-Filter) zur digitalen Nachfilterung im Zwischenfrequenz- und I-Q-Mischungsbereich zerlegt. Auf diese Weise kann die digitale Komponente zur digitalen Nachfilterung mit dem Korrelator integriert werden.

Statt der quasi-parallelen Durchführung der Vorfilterung und Faltung des Auflösungfilters in Echtzeit werden in einer Ausführungsform des erfindungsgemäßen Spektrumanalysators die im Vorfilter vorgefilterten Abtastwerte der Eingangsfunktion vom Vorfilter in Echtzeit in einen digitalen Speicher abgespeichert, aus dem sie der Korrelator zur zeitversetzten Faltung asynchron ausliest. Somit wird die Faltung von der Vorfilterung vollkommen zeitlich entkoppelt im Offline-Betrieb durchgeführt.

In einem Spektrumanalysator wird der Korrelator anstelle einer zeitaufwändigen Berechnung der Faltung in Zeitbereich mittels Multiplikation im Frequenzbereich unter Anwendung von Algorithmen der Fast-Fourier-Transformation realisiert.

Während in einer Ausführungsform des erfindungsgemäßen Spektrumanalysators einzig der gesamte Eingangsfrequenzbereich des zu analysierenden Meßsignals vermessen wird, werden in einem anderen Spektrumanalysator ein oder mehrere Teilfrequenzbereiche des gesamten Eingangsfrequenzbereichs zusätzlich zum oder ohne den gesamten Eingangsfrequenzbereich gleichzeitig jeweils mit unterschiedlichen Auflösebandbreiten vermessen und in mehreren Fenstern einer Anzeige dargestellt. Hierzu wird für jeden darzustellenden Frequenzbereich jeweils ein Vorfilter mit einer zur gewünschten Auflösung des Frequenzbereichs korrelierenden Bandbreite in Serie oder parallel geschaltet und das in den einzelnen Vorfiltern mit unterschiedlichen Bandbreiten vorgefilterte Eingangsignal jeweils über einen Analog-Digital-Wandler mit einer zur Bandbreite des jeweiligen Vorfilters passenden Abtastfrequenz abgetastet und jeweils einem Korrelator zur anschließenden Faltung zugeführt. Die einzelnen Korrelatoren können aufgrund der ihnen zugeführten Signale, die mit unterschiedlicher Abtastfrequenz abgetastet sind, unterschiedlich aufwändig realisiert sein.

Schließlich wird in einer Ausführungsform des erfindungsgemäßen Spektrumanalysators anstelle eines Sägezahngenerators ein Funktionsgenerator zur Erzeugung einer dreiecksförmigen Zeitfunktion eingesetzt, dessen ansteigende und abfallende Frequenzrampe eine unterschiedliche Steigung aufweist. Auf diese Weise kann der gesamte Eingangsfrequenzbereich des zu analysierenden Meßsignals in der Phase der ansteigenden und der abfallende Frequenzrampe mit jeweils unterschiedlichen minimalen Auflösebandbreiten aufgenommen werden.

Die Ausführungsformen des erfindungsgemäßen Spektrumanalysators werden nachfolgend unter Bezugnahme auf die Zeichnung näher erläutert. In der Zeichnung zeigen:

Fig. 1     ein Blockschaltbild eine Spektrumanalysators nach den Überlagerungsprinzip,

Fig. 2     ein Blockschaltbild eines Auflösungfilters einer ersten Ausführungsform eines nicht erfindungsgemäßen Spektrumanalysators,

Fig. 3     ein Blockschaltbild eines Auflösungfilters einer zweiten Ausführungsform eines nicht erfindungsgemäßen Spektrumanalysators,

Fig. 4     ein Blockschaltbild eines Auflösungfilters einer ersten Ausführungsform des erfindungsgemäßen Spektrumanalysators,

Fig. 5     ein Blockschaltbild eines Auflösungfilters eines Spektrumanalysators,

Fig. 6     ein Blockschaltbild eines Auflösungfilters eines Spektrumanalysators,

Fig. 7    ein Blockschaltbild eines Auflösungfilters eines Spektrumanalysators und

Fig. 8    ein Blockschaltbild eines Spektrumanalysators.

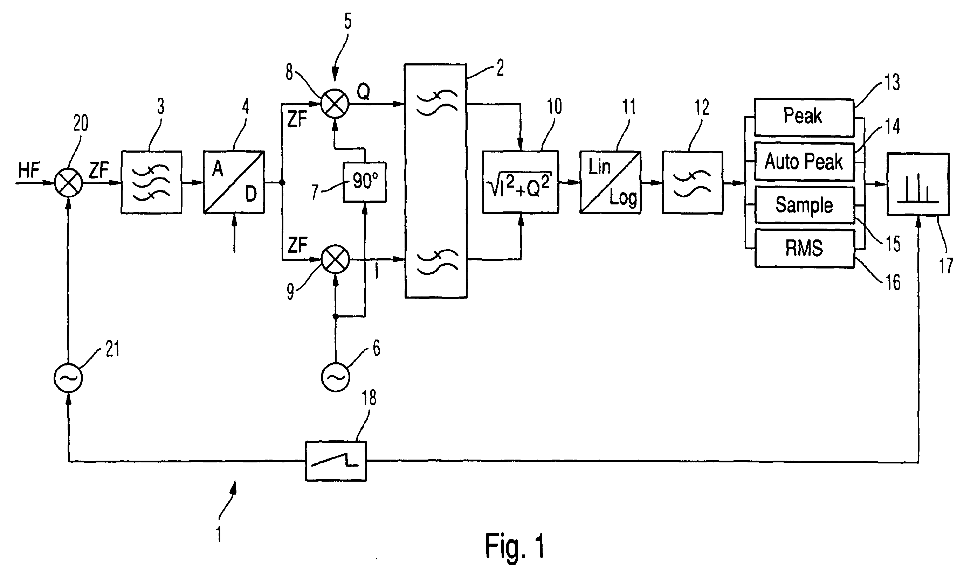

Fig. 1 zeigt einen Spektrumanalysator 1, bei welchem das Auflösungsfilter 2 zum Einsatz kommt, im Überblick.
Das mit HF bezeichnete Hochfrequenzsignal am Eingang des Spektrumanalysators 1 wird mittels des Mischer 20, dem das in einem Frequenzoszillator 21 erzeugte Mischersignal zugeführt wird, in das Zwischenfrequenzsignal ZF umgesetzt. Das Zwischenfrequenzsignal ZF wird in einem Bandpaß 3 gefiltert. An den Bandpaß 3 schließt sich ein Analog-Digital-Wandler 4. an. Anschließend folgt die I/Q-Mischung in einem I/Q-Demodulator 5, der in üblicher Weise aus einem lokalen Oszillator 6 und einem 90 Grad-Phasenschieber 7 zur Erzeugung zweier um 90 Grad phasenverschobener Mischersignale besteht, die zusammen mit dem gefilterten und analog/digital-gewandelten Zwischenfrequenzsignal jeweils einem Mischer 8 des Q-Zweigs und einem Mischer 9 des 1-Zweigs zugeführt werden.
Daran schließt sich die digitale Filterung mit dem Auflösungsfilter 2 an. Schließlich erfolgt die Hüllkurvengleichrichtung in einem Hüllkurvengleichrichter 10. Die Logarithmierung erfolgt in einem Logarithmierer 11. Auf den Logarithmierer 11 folgt ein Videofilter 12, in welchem die Videofilterung erfolgt.
Für die Detektion können unterschiedliche Detektoren 13 bis 16, beispielsweise ein Peak-Detektor 13, ein Auto-Peak-Detektor 14, ein Sample-Detektor 15 und ein RMS (Route Mean Square)-Detektor 16 zur Verfügung stehen. Je nach Anforderungen können entweder alle vier Detektoren bei einem Spektrumanalysator 1 mit hoher Performance eingebaut werden, oder es können nur bestimmte Detektoren, z. B. bei spezialisierten Messaufgaben nur ein einziger Detektor, eingebaut werden. Die Darstellung der detektierten Frequenz-Komponenten erfolgt in einer Anzeige 17.
Die Ansteuerung des lokalen Oszillators 21 und der Anzeige 17 erfolgt z. B. über einen Sägezahngenerator 18.

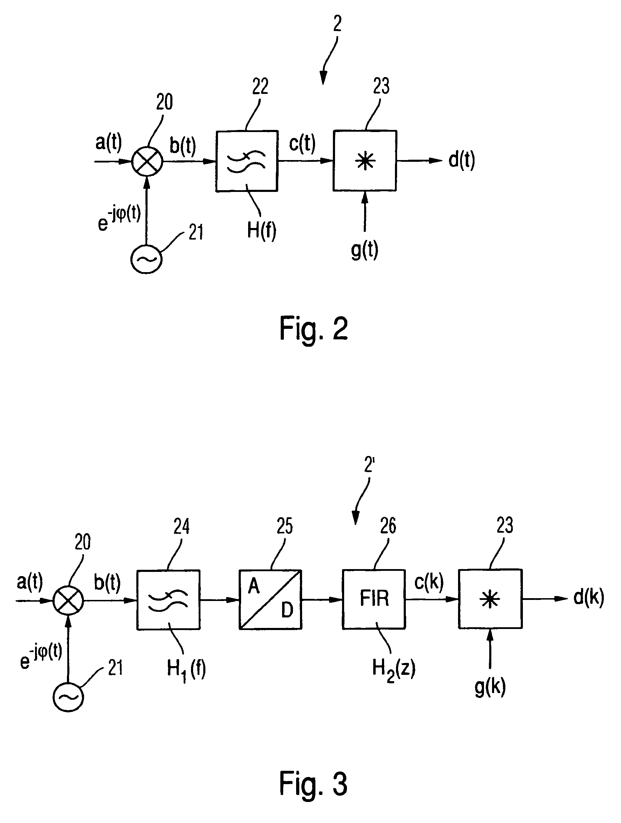

Fig. 2 zeigt ein vereinfachtes Blockschaltbild des Mischers 20, des Frequenzoszillators 21, des Bandpasses 3, des Analog-Digital-Wandlers 4, des I/Q-Demodulators 5 und des Auflösungfilters 2 des Spektrumanalysators 1 aus Fig. 1 als Auflösungfilter 2 des Spektrumanalysators 1. Hierbei wird der Bandpaß 3, der Analog-Digital-Wandler 4, der I/Q-Demodulator 5 und das Auflösungsfilter 2 näherungsweise durch das Auflösungsfilter 22 mit Tiefpaßcharakteristik modelliert. Das zu analysierende komplexe Hochfrequenz-Eingangsignal a(t) wird einem Mischer 20 zugeführt und durch Multiplikation mit dem Sweep-Signal $e^{-j\varphi(t)}$, das in einem lokalen Oszillators 21 erzeugt wird, in das Basisbandssignal b(t) heruntergemischt. Das Basisbandsignal b(t) wird dem Auflösungsfilter 2 zugeführt. Dieses Auflösungsfilter 2 besteht aus einem Vorfilter 22 mit der Übertragungsfunktion H(f) und der dazu korrespondierenden Impulsantwort h(t), das das Basisbandsignal b(t) entsprechend seiner Impulsantwort h(t) vorfiltert, und einem nachgeschalteten Korrelator 23, der das vorgefilterte Basisbandsignal c(t) mit einer Korrekturfunktion g(t) faltet. Am Ausgang des Korrelators 23 steht ein Ausgangssignal d(t) an, das aus einer Vorfilterung eines Basisbandsignals b(t) und einer anschließenden Faltung mit der Korrekturfunktion g(t) entsteht.
Im Hinblick auf ein besseres Verständnis des eigentlichen Erfindungsgedankens wird das Übertragungsverhalten des Auflösungfilters 2 im folgenden im Detail diskutiert:
Da das Auflösungsfilter 2 einzig aus linearen Komponenten - lineares Vorfilter 22 und linearer Korrelator 23 - besteht, kann von einem linearen Gesamtübertragungsverhalten des Auflösungfilters 2 ausgegangen werden, so dass in der folgenden linearen Betrachtung alle Übertragungseigenschaften des Auflösungfilters 2 erfasst werden.
Für die Betrachtung wird gemäß Gleichung (1) ein Eingangsignal a(t) mit einer einzigen festen Frequenz f und einer konstanten Amplitude mit dem Einheitswert 1 ausgegangen. Hierbei wird mit $W = e^{j2\pi}$ eine übliche Abkürzung der Signaltheorie eingeführt.

$$a(t) = e^{j2\pi f t} = W^{ft} \qquad\qquad (1)$$

Das Eingangsignal a(t) wird im Mischer 20 gemäß Gleichung (2) mit dem Sweep-Signal $e^{-j\varphi(t)}$ zu einem Ba- sisbandsignal b(t) gemischt.

$$b(t) = a(t)e^{-j\varphi(t)} \qquad\qquad (2)$$

Das Sweep-Signal $e^{-j\varphi(t)}$ enthält ein zeitabhängiges Phasensignal $\varphi(t)$, das gemäß Gleichung (3) von der zeitabhängigen Frequenz $f_M(t)$ abhängig ist.

$$\varphi(t) = 2\pi \frac{\partial f_M(t)/\partial t}{2} t^2 \qquad (3)$$

Die Momentanfrequenz $f_M$(t) wird im lokalen Oszillator 21 entsprechend dem Ansteuersignal des Sägezahngenerators 18 als linear ansteigende Frequenzrampe erzeugt, deren Zeitfunktion sich entsprechend Gleichung (4) ergibt. Hierbei stellen die Frequenzen $f_A$ und $f_B$ die Grenzen des zu analysierenden Frequenzbereiches, $f_z$ die Zwischenfrequenz des Auflösungsfilters 2 und $t_s$ die Zeitdauer für das Durchfahren - Sweepen - des Frequenzbereiches dar.

$$f_M(t) = f_A + \underbrace{\frac{f_B - f_A}{t_S}}_{=v_S} t - f_z \qquad (4)$$

Hierbei wird berücksichtigt, dass die Zwischenfrequenz $f_z$ des Auflösungfilters 2 niederfrequenter als das Frequenzband des zu vermessenden Meßsignals a(t) ist und das Meßsignal a(t) mit seinem zu vermessenden Frequenzband mittels Mischung im Mischer 20 mit der Mischerfrequenz gemäß Gleichung (4) zur Zwischenfrequenz des Auflösungsfilters 2 umgesetzt wird, die der Mittenfrequenz des als Bandpaß-Filter ausgelegten Auflösungfilters 2 entspricht.

Definiert man gemäß Gleichung (5) die Sweepgeschwindigkeit $V_s$ als die Geschwindigkeit zum Durchfahren des Frequenzbandes $\Delta f$ in der Sweep-Zeit $t_s$, so kann das Phasensignal $\varphi$(t) aus Gleichung (3) nach Gleichung (6) dargestellt werden.

$$v_S = \Delta f / t_s \quad \mathrm{mit} \quad \Delta f = f_B - f_A \qquad (5)$$

$$\varphi(t) = 2\pi \frac{v_S}{2} t^2 \qquad (6)$$

Unter Anwendung von Gleichung (6) ergibt sich folglich für die Momentanfrequenz $f_M$(t) des Sweep-Signals $e^{-j\varphi(t)}$ die in Gleichung (7) dargestellte Zeitbeziehung:

$$f_M(t) = \frac{\partial \varphi(t)/\partial t}{2\pi} - f_z = v_S * t - f_z \qquad (7)$$

Die Beziehung in Gleichung (7) kann durch Zeitverschiebung leicht in die Beziehung in Gleichung (4) übergeführt werden.

Die Vorfilterung des Basisbandssignals b(t) im Vorfilter 22 mit der Filterübertragungsfunktion H(f) entspricht gemäß Gleichung (8) einer Faltung des Basisbandssignals b(t) mit der Impulsantwort h(t) des Vorfilters 22.

$$c(t) = \int b(\tau) h(t - \tau) d\tau \qquad (8)$$

Das vorgefilterte Signal c(t) am Ausgang des Vorfilters 22 wird im Korrelator 23 mit der Korrekturfunktion g(t) gefaltet. Die Korrekturfunktion g(t), die gemäß Gleichung (9) von der Sweepgeschwindigkeit $v_s$ des erfindungsgemäßen Spektrumanalysators 1 abhängig ist, kompensiert den verzerrenden Einfluss der Frequenzrampe des Sweep-Signals $e^{-j\phi(t)}$ auf das zu vermessende Eingangsignal a(t).

$$g(t) = e^{j2\pi\frac{v_S}{2}t^2} = W^{\frac{v_S}{2}t^2} \tag{9}$$

Das Ausgangssignal d(t) des Auflösungfilters 2 ergibt sich gemäß Gleichung (10):

$$d(t) = \int c(u)g(t-u)du \tag{10}$$

Durch Einsetzen der Beziehung für das vorgefilterte Signal c(t) aus Gleichung (8) in die Gleichung (10) ergibt sich für das Faltungsergebnis d(t) des Korrelators 23 die in Gleichung (11) dargestellte Beziehung:

$$d(t) = \int\int b(\tau)h(u-\tau)d\tau g(t-u)du \tag{11}$$

Wird die Beziehung des Phasensignals $\varphi(t)$ aus Gleichung (6) in die Beziehung des Basisbandsignals b(t) in Gleichung (2) eingesetzt und die daraus entstehende neue mathematische Beziehung für das Basisbandsignal b(t) zusammen mit der mathematischen Beziehung für das Korrektursignal g(t) aus Gleichung (9) in Gleichung (11) eingesetzt, so ergibt sich für das Ausgangssignal d(t) des Auflösungsfilters 2 die in Gleichung (12) dargestellte Beziehung:

$$d(t) = \int\int W^{-\frac{v_S}{2}\tau^2+f\tau}h(u-\tau)W^{\frac{v_S}{2}(t-u)^2}dud\tau$$
$$= W^{\frac{v_S}{2}t^2}\int\int h(u-\tau)W^{\frac{v_S}{2}(-\tau^2-2tu+u^2)+f\tau}dud\tau \tag{12}$$

Wird nun die neue Variable z=u-τ in Gleichung (12) eingesetzt, so ergibt sich die in Gleichung (13) dargestellte neue Beziehung für das Ausgangssignal d(t) des Auflösungsfilters 2:

$$d(t) = W^{\frac{v_S}{2}t^2}\int\int h(z)W^{\frac{v_S}{2}(-2t(z+\tau)+z^2+2z\tau)+f\tau}dzd\tau$$
$$= W^{\frac{v_S}{2}t^2}\int\int h(z)W^{\frac{v_S}{2}z^2}W^{-v_S(tz+t\tau-z\tau)+f\tau}dzd\tau \tag{13}$$

Substituiert man in der mathematischen Beziehung für das Ausgangssignal d(t) des Auflösungsfilters 2 die Funktion $h(z)*W^{v_S/2*z^2}$ durch die Hilfsimpulsantwort $h_1(z)$, so erhält man den in Gleichung (14) dargestellten mathematischen Zusammenhang für das Ausgangssignal d(t) des Auflösungsfilters 2:

$$d(t) = W^{\frac{v_S t^2}{2}} \iint h_1(z) W^{-v_S z(t-\tau)} dz \, W^{-v_S t\tau + f\tau} d\tau \qquad (14)$$

Ersetzt man weiters die Zeitvariable z in der mathematischen Beziehung des Ausgangssignals d(t) des Auflösungfilters 2 in Gleichung (14) mit der Substitution z=y/v durch eine Momentanfrequenzvariable y, so folgt für das Ausgangssignal d(t) des Auflösungfilters 2 die mathematische Beziehung in Gleichung (15):

$$d(t) = \frac{1}{v_S} W^{v_S/2 \cdot t^2} \iint h_1(y/v_s) W^{-y(t-\tau)} dy \, W^{-v_S t\tau + f\tau} d\tau \qquad (15)$$

Wird schließlich in der mathematischen Beziehung des Ausgangssignals d(t) des Auflösungfilters 2 die Hilfsimpulsantwort $h_1(z)=h_1(y/v_s)$ durch eine weitere Hilfsimpulsantwort $h_2(y)$ ersetzt, so ergibt sich Gleichung (16) für das Ausgangssignal d(t) des Auflösungfilters 2:

$$d(t) = \frac{1}{v_S} W^{v_S/2 \cdot t^2} \iint h_2(y) W^{-y(t-\tau)} dy \, W^{-v_S t\tau + f\tau} d\tau \qquad (16)$$

In Gleichung (16) erkennt man die Berechnungsformel zur Berechnung der Fourier-Transformierten $H_2(t-\tau) = \Im\{h_2(y)\}|_{t-\tau}$, die gemäß Gleichung (17) lautet:

$$H_2(t-\tau) = \Im\{h_2(y)\}|_{t-\tau} = \int h_2(y) * e^{-j2\pi(t-\tau)} dy \qquad (17)$$

.

Zu erwähnen ist hierbei, dass die Fourier-Transformation vom Frequenzbereich in den Zeitbereich durchgeführt wird, da das Argument der Hilfsimpulsantwort $h_2(y)$ die Frequenzvariable y und das Argument der Fourier-Transformierten $H_2(t-\tau)$ die Zeitvariable $t-\tau$ ist. Durch Einführung der Fourier-Transformierten $H_2(t-\tau)$ in der Beziehung des Ausgangssignals d(t) des Auflösungfilters 2 in Gleichung (17) folgt Gleichung (18):

$$d(t) = \frac{1}{v_S} W^{\frac{v_S t^2}{2}} \int H_2(t-\tau) W^{(f-v_S t)\tau} d\tau \qquad (18)$$

Da in einem Spektrumanalysator die Meßergebnisse im Frequenzbereich dargestellt werden, ist folglich eine mathematische Beziehung für das Ausgangssignal $d(f_m)$ des Auflösungfilters 2 mit der Messefrequenz $f_m$ als Argument zu ermitteln. Hierzu wird ausgehend von Gleichung (18) die Zeitdifferenz $t-\tau$ durch die neue Hilfsvariable x substituiert, womit sich Gleichung (19) mit dem Ausgangssignal d(t) des Auflösungfilters 2 ergibt.

$$d(t) = \frac{1}{v_S} W^{\frac{v_S}{2}t^2} \int H_2(x) W^{(f-v_St)(t-x)} dx$$

$$= \frac{1}{v_S} W^{\frac{v_S}{2}t^2} \int H_2(x) W^{ft-fx-v_2t^2+v_2tx} dx$$

$$= \frac{1}{v_S} W^{-\frac{v_S}{2}t^2+ft} \int H_2(x) W^{(v_St-f)x} dx \qquad (19)$$

Gleichung (19) stellt die Beziehung zur Berechnung der inversen Fourier-Transformation aus der Fourier-Transformierten $H_2(x)$ dar. Führt man nun auf der Basis von Gleichung (19) diese inverse Fourier-Transformation auf die Fourier-Transformierte $H_2(x)$ durch, so ergibt sich mit der Hilfsimpulsantwort $h_2(v_St-f)$ als Ergebnis der inversen Fourier-Transformation die Beziehung für das Ausgangssignal $d(t)$ des Auflösungfilters 2 in Gleichung (20):

$$d(t) = \frac{1}{v_S} W^{-\frac{v_S}{2}t^2+ft^{-1}} F^{-1}(H_2)(v_St-f)$$

$$= \frac{1}{v_S} W^{-\frac{v_S}{2}t^2+ft} h_2(v_St-f) \qquad (20)$$

Aus Gleichung (20) ergibt sich für das Ausgangssignal $d(t)$ des Auflösungfilters 2 Gleichung (19), wenn die Hilfsimpulsantwort $h_2(v_St-f)$ durch die ursprüngliche Hilfsimpulsantwort $h_1((v_St-f)/v_S)$ wieder resubstituiert wird:

$$d(t) = \frac{1}{v_S} W^{-\frac{v_S}{2}t^2+ft} h_1(t-f/v_S) \qquad (21)$$

Wird die Hilfsimpulsantwort $h_1(t-f/v_S)$ in Gleichung (21) durch die ursprüngliche Impulsantwort $h(t-f/v_S)$ *$W^{v_S/2*(t-fv_S)2}$ wieder resubstituiert und die Abkürzung W wieder aufgelöst, so folgt Gleichung (22) für das Ausgangssignal $d(t)$ des Auflösungfilters 2:

$$\mathrm{d(t)} = \frac{1}{v_S} W^{-\frac{v_S}{2}t^2+ft} h(t-f/v_S) W^{\frac{v_S}{2}(t-f/v_S)^2}$$

$$= \frac{1}{v_S} W^{\frac{f^2}{2v_S}} h(t-f/v_S)$$

$$= \frac{1}{v_S} e^{j\pi\frac{f^2}{v_S}} h(t-f/v_S) \qquad (22)$$

Um das Ausgangssignal $d(f_m)$ des Auflösungfilters 2 mit der Messfrequenz $f_m$ als Argument anstelle des Zeitarguments t zu ermitteln, ist der Zusammenhang zwischen der Meßfrequenz $f_m$ und der Zeit t zu ermitteln. Die aktuell mit dem Spektrumanalysator 1 gemessene Meßfrequenz $f_m(t)$ des Meßsignals $a(t)$ ergibt sich gemäß Gleichung (23) aus der Addition der Momentanfrequenz $f_M(t)$ des Sweep-Signals $e^{-j\phi(t)}$ und der Zwischenfrequenz $f_z$ des Auflösungfilters 2.

$$f_m(t) = f_M(t) + f_Z \qquad (23)$$

Berücksichtigt man die Beziehung der Momentanfrequenz $f_M(t)$ des Sweep-Signals aus Gleichung (7) in Gleichung (23), so erhält man für die aktuelle Meßfrequenz $f_m(t)$ die in Gleichung (24) dargestellte mathematischen Beziehung:

$$f_m(t) = v_S * t \qquad (24)$$

Substituiert man in Gleichung (22) für das Ausgangssignal d(t) des Auflösungfilters 2 das Zeitargument t entsprechend Gleichung (24) durch das Argument $f_m(t)/v_s$, so ergibt sich Gleichung (25) für das Ausgangssignal $d(f_m(t)/v_s)$:

$$d(f_m(t)/v_S) = \frac{1}{v_S} e^{j\pi \frac{f^2}{v_S}} h((f_m(t) - f)/v_S) \qquad (25)$$

Ersetzt man in Gleichung (25) das Ausgangssignal $d(f_m(t))$ durch das Ersatzausgangssignal $d_1(f_m(t))$, so erhält man mit der Beziehung für $d_1(f_m(t))$ in Gleichung (26) einen mathematischen Ausdruck für das Ausgangssignal des Auflösungfilters 2 als Funktion der Messfrequenz $f_m$:

$$d_1(f_m) = \frac{1}{v_S} e^{j\pi \frac{f^2}{v_S}} h((f_m - f)/v_S) \qquad (26)$$

Interpretiert man die Ergebnisse für das Ausgangssignal des Auflösungfilters 2 in Gleichung (22) für den Zeitbereich und in Gleichung (26) für den Frequenzbereich im Hinblick auf die Erfüllung der Erfindungsaufgabe, so können folgende Feststellungen hinsichtlich des Erfüllungsgrades der Erfindungsaufgabe durch den erfindungsgemäßen Spektrumanalysator 1 getroffen werden:

Da das Ausgangssignal d(t) des Auflösungfilters 2 im Zeitbereich gemäß Gleichung (22) keine komplexen vom Zeitargument t abhängigen Terme aufweist, falls die Impulsantwort h(t) des Vorfilters 22 rein reell gestaltet ist, kann jedes beliebige Eingangsignal a(t) niemals durch das Auflösungfilter 2 zum Schwingen angeregt werden. Insofern ist die Bandbreite des Auflösungfilters 2, insbesondere die Bandbreite des zum Auflösungfilters 2 gehörigen Vorfilters 22, im Hinblick auf eine Dämpfung derart auftretender Schwingungen nicht zu erhöhen. Die mit dem Auflösungfilters 2 realisierte Auflösung des erfindungsgemäßen Spektrumanalysators 1 wird deshalb im Gegensatz zum Stand der Technik nicht unnötig reduziert.

Hinzukommt, dass der Phasenfaktor $\exp(j\pi f^2/v_s)$ des Ausgangssignals $d(f_m)$ des Auflösungfilters 2 im Frequenzbereich von der Meßfrequenz $f_m$ unabhängig ist. Liegen nämlich zwei Spektrallinien eines analysierenden Eingangsignals a(t) hinsichtlich ihres Frequenzabstandes so nahe beieinander, dass bei gegebener Auflösungsbandbreite des Auflösungfilters 2 die durch die Vorfilterung und anschließende Faltung mittels Auflösungsfilter 2 resultierenden Frequenzspektren der beiden Spektrallinien sich in einem gewissen Frequenzbereich überlappen, so kann es in diesem überlappenden Frequenzbereich zu zu Mitkopplung führenden Phasenüberlagerungen der Phasenfaktoren in den Frequenzspektren der beiden Spektrallinien kommen.

Aus Gleichung (26) erkennt man, dass ein mit fester Frequenz f schwingendes Eingangsignal a(t) am Ausgang des Korrelators 23 bezüglich der Meßfrequenz $f_m$ verbreitert wird. Diese frequenzmäßige Verbreiterung wird einerseits durch die zeitliche Länge $\Delta t_{VF}$ der Impulsantwort h(t) des Vorfilters 22 und andererseits durch die Sweep-Geschwindigkeit $v_s$, die im Argument der Impulsantwort h zu einer Division der Meßfrequenz $f_m$ führt, bestimmt. Um eine frequenzmäßige Verbreiterung des Eingangsignal a(t) am Ausgang des Korrelator 23 im Hinblick auf eine möglichst hohe Auflösung $B_A$ des erfindungsgemäßen Spektrumanalysators 1 weitestgehend zu minimieren, ist die Impulsantwort h(t) des Vorfilters 22 im Zeitbereich bezüglich ihrer zeitliche Länge $\Delta t$ möglichst kurz zu gestalten, was mit einer Erhöhung der Bandbreite

$\Delta f_{VF}$ der korrespondierenden Übertragungsfunktion H(f) des Vorfilters 22 in Frequenzbereich verbunden ist.

Im Gegensatz zum Stand der Technik nach DE 101 05 258 A1, in dem eine hohe Auflösung $B_A$ des Spektrumanalysators durch Schmalbandigkeit des Auflösungfilters erzielt wird, wird eine hohe Auflösung $B_A$ des erfindungsgemäßen Spektrumanalysators 1 durch eine möglichst kurze Impulsantwort h(t) des Vorfilters 22 im Zeitbereich und damit korrelierend eine hohe Breitbandigkeit der Übertragungsfunktion H(f) des Vorfilters 22 im Frequenzbereich gewonnen. Die maximale Bandbreite des Vorfilters 22 ist aber durch die maximale Abtastrate eines im erfindungsgemäßen Spektrumanalysator 1 integrierten Analog-Digital-Wandlers und durch die Bandbreite der analog realisierten Filterkomponente des Vorfilters 22 nach oben begrenzt.

Eine zusätzliche frequenzmäßige Verbreiterung des Eingangsignals a(t) am Ausgang des Korrelator 23 im Hinblick auf eine möglichst hohe Auflösung $B_A$ des erfindungsgemäßen Spektrumanalysator 1 kann nur noch durch Verkleinerung der Sweep-Geschwindigkeit $v_s$ gewonnen werden. Im Gegensatz zum Spektrumanalysator der Stand der Technik nach DE 101 05 258 A1 verhalten sich die Bandbreite $B_{RES}$ des Auflösungfilters und die Sweep-Geschwindigkeit $v_s$ des Spektrumanalysators nicht mehr gegenläufig. Insofern muss eine Minimierung des K-Faktors beim erfindungsgemäßen Spektrumanalysator 1 nicht mehr angestrebt werden. Die Auflösungsbegrenzung des erfindungsgemäßen Spektrumanalysators 1 ist vielmehr durch die nach oben begrenzte Abtastfrequenz des Analog-Digital-Wandlers und durch die nach oben begrenzte Bandbreite $B_{RES}$ der analog realisierten Filterkomponente des Vorfilters 22 bestimmt.

In Fig. 3 ist ein zweiter Auflösungfilters 2' in einem Spektrumanalysator 1 dargestellt. Gleiche Elemente des zweiten Auflösungfilters 2 werden mit gleichen Bezugszeichen dargestellt und im einzelnen nicht mehr erklärt.

Im Gegensatz zum ersten Auflösungfilter wird das analoge Vorfilters 22 mit der Übertragungsfunktion H(f) in eine analoge Filterkomponente 24 mit Übertragungsfunktion $H_1(f)$, die sich an den Mischer 20 anschließt, einen daran anschließenden Analog-Digital-Wandler 25 zur Analog-Digital-Wandelung des in der analogen Filterkomponente 24 vorgefilterten Basisbandssignals b(t) und einer daran anschließenden digitalen Filterkomponente 26, die als nicht-rekursives digitales Filter (FIR-Filter) mit der Übertragungsfunktion $H_2(z)$ ausgeführt ist, zerlegt. Auf diese Weise kann die digitale Filterkomponente 26 und der digital realisierte Korrelator 23 in einem einzigen integrierten Baustein aufwandsminimiert realisiert werden. Die Nicht-Rekursiviität der digitalen Filterkomponente 26 ist zwingende Voraussetzung zur Verwirklichung eines zeitlich begrenzten vorgefilterten Basisbandssignals c(k), um den Rechenaufwand der digitalen Faltung des zeitdiskreten vorgefilterten Basisbandssignals c(k) mit der zeitdiskreten Korrekturfunktion g(k) im Korrelator 23 in einem realistischen Größenbereich zu beschränken.

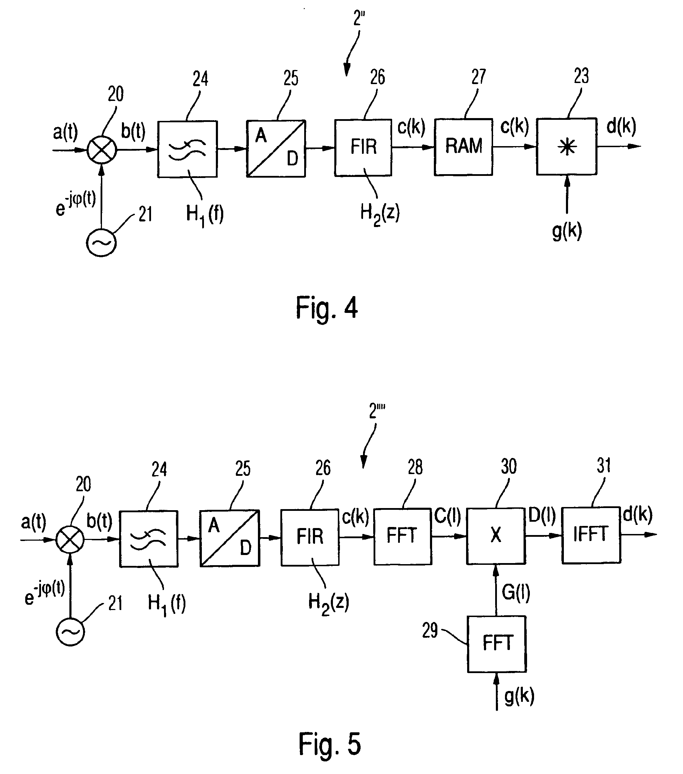

In Fig. 4 ist eine erste Ausführungsform eines erfindungsgemäßen Auflösungfilters 2" in einem erfindungsgemäßen Spektrumanalysator 1 dargestellt.

Hierbei wird in Abgrenzung zum zweiten Auflösungfilter 2' des Spektrumanalysators 1 im Anschluss an die digitale Filterkomponente 26 ein digitaler Speicherbaustein (RAM) 27 eingeführt, in dem die digitale Filterkomponente 26 die Abtastwerte des vorgefilterten Basisbandssignals c(k) im Takt der Abtastfrequenz in Echtzeit abspeichert. Aus diesem digitalen Speicherbaustein 27 liest der digital realisierte Korrelator 23 vollkommen zeitasynchron zur Echtzeitfilterung des Vorfilters 24 und 26 die abgespeicherten Abtastwerte des vorgefilterte Basisbandsignals c(k) aus, um sie im Offline-Betrieb mit der zeitdiskreten Korrekturfunktion g(k) zu falten.

In Fig. 5 ist ein Auflösungfilter 2'''' in einem erfindungsgemäßen Spektrumanalysator 1 dargestellt. Im Gegensatz zum zweiten Auflösungfilter 2' in Fig. 3 wird anstelle einer sehr rechenaufwändigen Faltung des Korrelators 23 im Zeitbereich eine weniger aufwändige Multiplikation im Frequenzbereich durchgeführt.

Hierzu wird das zeitdiskrete vorgefilterte Basisbandsignal c(k) in einer Einheit 28 zur Durchführung einer Fourier-Transformation, die laufzeitoptimierte Algorithmen zur Durchführung einer Fast-Fourier-Transformation beinhaltet, in den Frequenzbereich zur Bildung der korespondierenden Fourier-Transformierten C(1) transformiert. Analog wird die zeitdiskrete Korrekturfunktion g(k) in einer Einheit 29 zur Durchführung einer Fourier-Transformation in den Frequenzbereich zur Bildung der korrespondierenden Fourier-Transformierten G(1) transformiert. Aus den beiden Fourier-Transformierten C(1) und G(1) wird über einen komplexen Multiplizierer 30 die Fourier-Transformierte D(1) des Ausgangsignals d(k) des Auflösungfilters 2'''' berechnet.

Anschließend erfolgt mit einer Einheit 31 zur Durchführung einer inversen Fourier-Transformation eine Berechnung des zeitdiskreten Ausgangsignals des Auflösungfilters 2 " " aus der Fourier-Transformierten D(1). Unter der Annahme einer rechenoptimierten Durchführung der Algorithmen der Fast-Fourier-Transformation bzw. der inversen Fast-Fourier-Transformation in den Einheiten 28, 29 und 30 und einer im Vergleich zur digitalen Faltung wesentlich einfacheren digitalen Multiplikation stellt der Auflösungfilter 2'''' eine rechen- und laufzeitoptimierte Lösung zur Realisierung eines Auflösungsfilters dar.

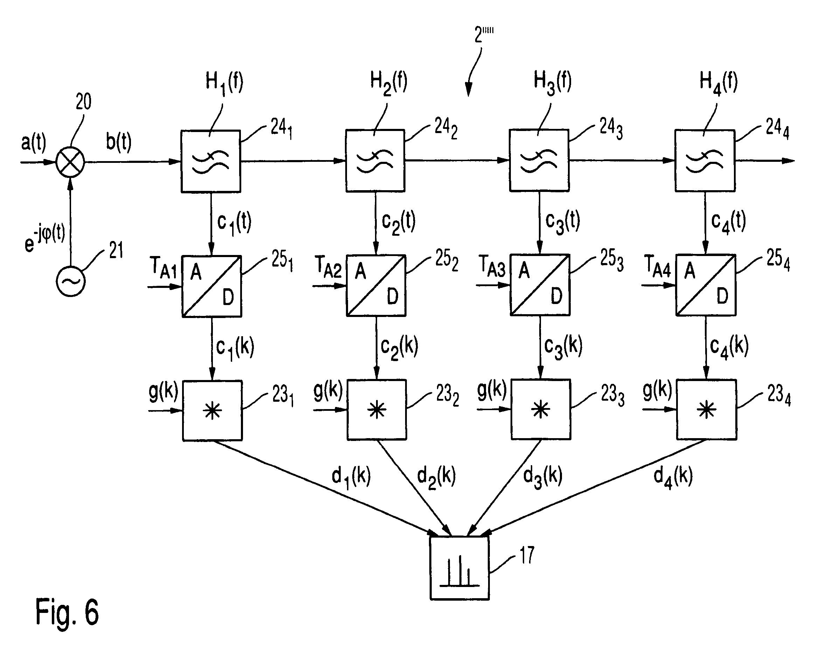

In Fig. 6 ist ein Auflösungfilter 2''''' in einem Spektrumanalysator 1 dargestellt.

In dem Auflösungfilter 2''''' in einem Spektrumanalysator 1 ist die analoge Filterkomponente 24 des Vorfilters 22 in mehrere, im dargestellten Beispiel in Fig. 6 in insgesamt vier, in Serie geschaltete analoge Filterkomponenten $24_1$, $24_2$, $24_3$ und $24_4$ unterteilt. Diese in Serie geschalteten analogen Filterkomponenten $24_1$, $24_2$, $24_3$ und $24_4$ stellen jeweils Tiefpaß-Filter mit unterschiedlicher Bandbreite dar. Auf diese Weise kann mit jeder dieser analogen Filterkomponenten $24_1$, $24_2$, $24_3$ und $24_4$ ein unterschiedlich großer Frequenzbereich innerhalb des gesamten Eingangsfrequenzbereichs des Basisbandssignals b(t) mittels Vorfilterung selektiert werden.

Auf Grund der dabei erzielten unterschiedlichen Bandbreiten der vorgefilterten Basisbandssignale $c_1(t)$, $c_2(t)$, $c_3(t)$ und $c_4(t)$ an den jeweiligen Ausgängen der analogen Filterkomponenten $24_1$, $24_2$, $24_3$ und $24_4$ können diese in jeweils nachfolgenden Analog-Digital-Wandlern $25_1$, $25_2$, $25_3$ und $25_4$ mit jeweils korrespondierenden unterschiedlichen Abtastraten $T_{A1}$, $T_{A2}$, $T_{A3}$ und $T_{A4}$ abgetastet werden (Nyquist-Kriterium). Die zeitdiskreten vorgefilterten Basisbandssignale $c_1(k)$, $c_2(k)$, $c_3(k)$ und $c_4(k)$ werden jeweils in den digitalen Korrelatoren $23_1$, $23_2$, $23_3$ und $23_4$ mit der zeitdiskreten Korrekturfunktion g(k) gefaltet, wobei diese digitalen Korrelatoren $23_1$, $23_2$, $23_3$ und $23_4$ auf Grund der unterschiedlichen Abtastfrequenzen $T_{A1}$, $T_{A2}$, $T_{A3}$ und $T_{A4}$ der zeitdiskreten vorgefilterten Basisbandsignale $c_1(k)$, $c_2(k)$, $c_3(k)$ und $c_4(k)$ mit unterschiedlicher Abtastrate arbeiten.

Der Korrelator $23_1$, der das zeitdiskrete vorgefilterte Basisbandsignal $c_1(k)$ mit der größten Bandbreite faltet, führt aufgrund der höchsten Abtastrate $T_{A1}$ am häufigsten die Faltung durch und der Korrelator $23_4$, der das zeitdiskrete vorgefilterte Basisbandsignal $c_4(k)$ mit der kleinsten Bandbreite faltet, führt auf Grund der niedrigsten Abtastrate $1/T_{A4}$ am wenigsten die Faltung durch. Wird der Korrelator $23_1$ dagegen in einer niedrigeren als der maximal möglichen Abtastfrequenz $1/T_{A1}$ betrieben, so erzielt man ein Ergebnis mit einer geringeren Auflösung. Auf diese Weise kann mit dem Vorfilter $24_1$ und dem Korrelator $23_1$ beispielsweise der gesamten Eingangsfrequenzbereich des Basisbandssignals b(t) mit einer geringeren Auflösung gemessen werden.

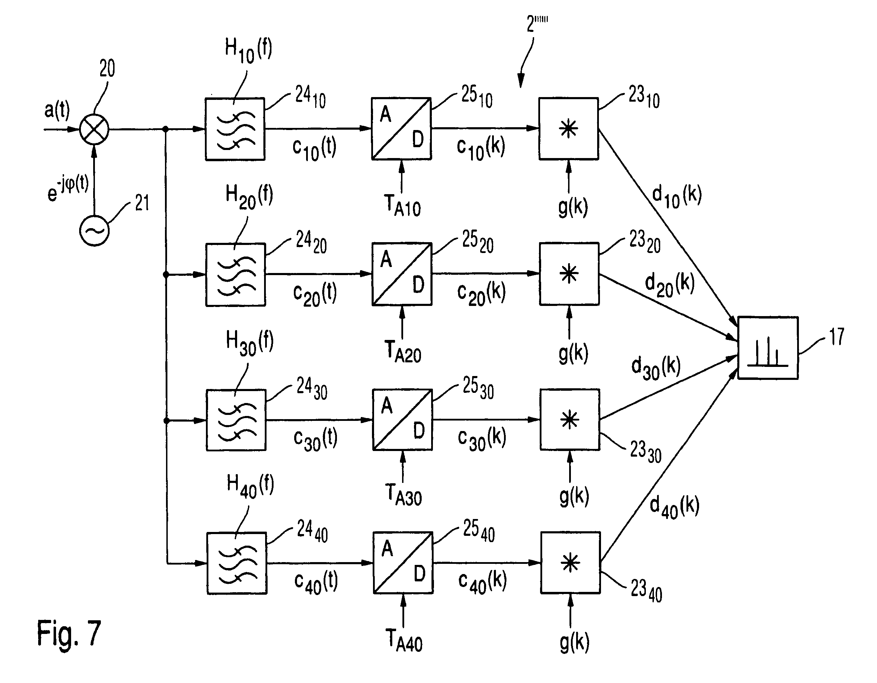

In Fig. 7 ist ein Auflösungfilter 2'''''' in einem Spektrumanalysator 1 dargestellt.

In dem Auflösungfilter 2'''''' in einem Spektrumanalysator 1 ist die analoge Filterkomponente 24 des Vorfilters 22 in mehrere, im dargestellten Beispiel in Fig. 7 in insgesamt vier, parallelgeschaltete analoge Filterkomponenten $24_{10}$, $24_{20}$, $24_{30}$ und $24_{40}$ aufgeteilt. Diese parallelgeschalteten analogen Filterkomponenten $24_{10}$, $24_{20}$, $24_{30}$ und $24_{40}$ stellen jeweils Bandpaß-Filter mit unterschiedlicher Mittenfrequenz und u. U. unterschiedlicher Bandbreite dar. Auf diese Weise kann mit jeder dieser analogen Filterkomponenten $24_{10}$, $24_{20}$, $24_{30}$ und $24_{40}$ ein bestimmtes Frequenzband innerhalb des gesamten Eingangsfrequenzbereichs des Basisbandssignals b(t) mit u. U. unterschiedlicher Frequenzbandbreite mittels Vorfilterung selektiert werden.

Auf Grund der dabei erzielten unterschiedlichen Bandbreiten der vorgefilterten Basisbandssignale $c_{10}(t)$, $c_{20}(t)$, $c_{30}(t)$ und $c_{40}(t)$ an den jeweiligen Ausgängen der analogen Filterkomponenten $24_{10}$, $24_{20}$, $24_{30}$ und $24_{40}$ können diese in jeweils nachfolgenden Analog-Digital-Wandlern $25_{10}$, $25_{20}$, $25_{30}$ und $25_{40}$ mit jeweils korrespondierenden unterschiedlichen Abtastraten $1/T_{A10}$, $1/T_{A20}$, $1/T_{A30}$ und $1/T_{A40}$ abgetastet werden (Nyquist-Kriterium). Die zeitdiskreten vorgefilterten Basisbandssignale $c_{10}(k)$, $C_{20}(k)$, $C_{30}(k)$ und $c_{40}(k)$ werden jeweils in den digitalen Korrelatoren $23_{10}$, $23_{20}$, $23_{30}$ und $23_{40}$ mit der zeitdiskreten Korrekturfunktion g(k) gefaltet, wobei diese digitalen Korrelatoren $23_{10}$, $23_{20}$, $23_{30}$ und $23_{40}$ auf Grund der unterschiedlichen Abtastfrequenzen $1/T_{A10}$, $1/T_{A20}$, $1/T_{A30}$ und $1/T_{A40}$ der zeitdiskreten vorgefilterten Basisbandssignale $c_{10}(k)$, $c_{20}(k)$, $c_{30}(k)$ und $c_{40}(k)$ mit unterschiedlicher Abtastrate arbeiten.

Schließlich kann die serielle Anordnungsstruktur der Vorfilter des Auflösungfilters 2'''''' mit der parallelen Anordnungsstruktur der Vorfilter eines Auflösungsfilters 2 '''''' beliebig kombiniert werden. Auf diese Weise können mehrere Teilfrequenzbänder aus einer beliebigen Stelle des gesamten Eingangsfrequenzbereiches mit beliebiger Teilfrequenzbandbreite selektiert werden und mit unterschiedlicher Auflösung gleichzeitig in einer Anzeige 17 eines erfindungsgemäßen Spektrumanalysators 1 dargestellt werden. Insbesondere ist es möglich, einerseits den gesamten Eingangsfrequenzbereich mit einer geringeren Auflösung und andererseits gleichzeitig einen Teilfrequenzbereich, in dem sich mehrere Spektrallinien oder Peaks befinden, mit einer hohen Auflösung aufzuzeichnen und darzustellen.

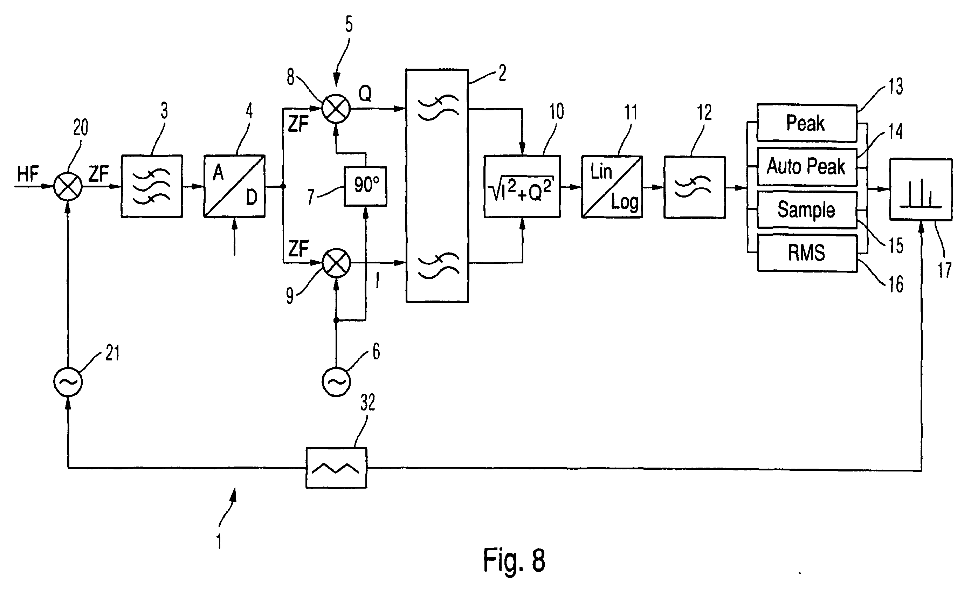

In Fig. 8 ist ein Spektrumanalysator 1' dargestellt, in der anstelle des Sägezahngenerators 18 ein Funktionsgenerator 32 mit einem dreiecksförmigen Zeitverlauf eingesetzt wird. Der Betrag der Steilheit der aufsteigenden und der absteigenden Flanke des dreiecksförmigen Zeitverlaufs sind unterschiedlich gestaltet. Auf diese Weise ist es möglich, den gesamten Eingangsfrequenzbereich des Eingangssignals a(t) sowohl mit der aufsteigenden als auch mit der abfallenden Frequenzrampe zu sweepen und aufgrund der unterschiedlichen Steilheit jeweils unterschiedliche Auflösungen der zu vermessenden Frequenzspektren zu erzielen.

Auf Grund von Linearitätsfehlern in gesteuerten Oszillatoren und Phasenregelkreisen kann es insbesondere bei den hohen Frequenzen im Bereich der oberen Grenzfrequenz des zu vermessenden Frequenzbandes zu Abweichungen zwischen der durch den Sägezahngenerator oder den dreiecksförmigen Funktionsgenerator vorgegebenen Sollfrequenz und der durch den Oszillator oder den Phasenregelkreis erzeugten Momentanfrequenz $f_M$ kommen. Da diese Linearitätsfehler insbesondere bei hoher Sweep-Geschwindigkeit und/oder hoher Auflösung nicht akzeptabel sind, müssen diese beseitigt werden, indem beispielsweise die digitale Frequenzteilung des Phasenistwertes am Eingang des Phasenreglers mit einem bestimmten Frequenzteilungswert nicht in gleichen Zeitabständen erfolgt, sondern die bei auftretenden Linearitätsfehlern für eine lineare Frequenzrampe erforderlichen optimierten Zeitabstände zum Schalten der Frequenzteilungswerte durch Kalibrierung ermittelt werden und anschließend beim Schalten der Frequenzteilungswerte benutzt werden.

Die Erfindung ist nicht auf die dargestellten Ausführungsformen beschränkt. Insbesondere können alle Merkmale aller Ausführungsformen vorteilhaft miteinander kombiniert werden.

Die wesentlichen Merkmale sind die Merkmale nach dem Anspruch 1.

**Patentansprüche**

1.  Spektrumanalysator (1), der nach dem Überlagerungsprinzip arbeitet, mit einem Sollfrequenzgeber (18, 32), einem lokalen Frequenzoszillator (21), einem Mischer (20), einem Auflösungsfilter (2; 2'; 2"; 2"'; 2 " " ; 2 " " ' ; 2 " " ") und einem Detektor (13, 14, 15, 16),
    wobei das Auflösungsfilter (2; 2'; 2"; 2"'; 2""; 2""'; 2 " " ") ein Vorfilter (22; 24, 26) und einen nachgeschalteten Korrelator (23) umfasst,
    wobei das Vorfilter (22; 24, 26) einen analogen Filteranteil (24) und einen sich anschließenden digitalen Filteranteil (26) umfaßt, das Vorfilter (22; 24, 26) eine von der Sweepgeschwindigkeit $v_s$ des Spektrumanalysators (1) unabhängige Impulsantwort h(t) als Funktion der Zeit t zur Vorfilterung eines mit dem Spektrumanalysator (1) zu vermessenden Eingangssignals a(t) aufweist und die vorgefilterten Abtastwerte c(k) der Eingangsfunktion a(t) in Echtzeit in einem digitalen Speicher (27) abspeichert, welche der Korrelator (23) asynchron ausliest, so dass die Faltung von der Vorfilterung vollkommen zeitlich entkoppelt im Offline Betrieb durchgeführt wird,
    und wobei der Korrelator (23) eine von der Sweepgeschwindigkeit $v_s$ des Spektrumanalysators (1) abhängige Korrekturfunktion g(t) als Funktion der Zeit t zur Faltung des im Vorfilter (22; 24, 26) vorgefilterten Eingangssignals a(t) aufweist.

2.  Spektrumanalysator nach Anspruch 1,
    **dadurch gekennzeichnet,**
    **daß** die Korrekturfunktion g(t) sich nach folgender Gleichung berechnet:

$$g(t) = e^{j2\pi^* v_s / 2^* t^2} \ .$$

3.  Spektrumanalysator nach Anspruch 1 oder 2,
    **dadurch gekennzeichnet,**
    **daß** der digitale Filteranteil (24) des Vorfilters (22; 24, 26) ein nicht rekursives digitales Filter enthält, das in den Korrelator (23) integriert ist.

4.  Spektrumanalysator nach einem der Ansprüche 1 bis 3,
    **dadurch gekennzeichnet,**
    **daß** der Korrelator (23) mit Algorithmen zur Durchführung der Fast-Fourier-Transformation realisiert ist.

5.  Spektrumanalysator nach einem der Ansprüche 1 bis 4,
    **dadurch gekennzeichnet,**
    **daß** der Sollfrequenzgeber (18; 32) ein Sägezahngenerator ist, der eine Frequenzrampe zur Ansteuerung des Frequenzoszillators (21) über den gesamten zu vermessenden Frequenzbereich des Eingangssignals a(t) erzeugt.

6.  Spektrumanalysator nach Anspruch 5,
    **dadurch gekennzeichnet,**
    **daß** der Spektrumanalysator (1) den gesamten zu vermessenden Frequenzbereich oder einen Teilfrequenzbereich des gesamten zu vermessenden Frequenzbereiches des Eingangssignals a(t) vermißt.

7.  Spektrumanalysator nach Anspruch 6,
    **dadurch gekennzeichnet,**
    **daß** der Spektrumanalysator den gesamten Frequenzbereich und/oder ein oder mehrere Teilfrequenzbereiche gleichzeitig mit unterschiedlicher Auflösebandbreite vermißt.

8.  Spektrumanalysator nach einem der Ansprüche 1 bis 7,
    **dadurch gekennzeichnet,**
    **daß** der Sollfrequenzgeber (18; 32) durch einen Funktionsgenerator zur Erzeugung einer dreiecksförmigen Zeitfunktion (32) realisiert ist, deren aufsteigende und absteigende Frequenzrampe unterschiedliche Steigung aufweist und zur Ansteuerung des Frequenzoszillators (21) jeweils über den gesamten zu vermessenden Frequenzbereich des Eingangssignals a(t) dient.

**Claims**

1. Spectrum analyser (1), which operates according to the superposition principle, comprising a target-frequency generator (18, 32), a local frequency oscillator (21), a mixer (20), a resolution filter (2; 2'; 2''; 2'''; 2''''; 2'''''; 2'''''') and a detector (13, 14, 15, 16),
wherein the resolution filter (2; 2'; 2'' ; 2''' ; 2'''' ; 2''''' ; 2'''''') comprises a pre-filter (22; 24, 26) and a correlator (23) connected downstream,
wherein the pre-filter (22; 24, 26) comprises an analog-filter component (24) and an adjacent digital-filter component (26),
wherein the pre-filter (22; 24, 26) provides an impulse response h(t) as a function of time t independent of the sweep velocity $v_s$ of the spectrum analyser (1) for the pre-filtering of an input signal a(t), which is to be measured, and stores in a digital memory (27) in real-time the pre-filtered sampling values c(k) of the input function a(t), which the correlator (23) reads out in an asynchronous manner, so that the convolution is implemented in offline operation completely decoupled in time from the pre-filtering,
and wherein the correlator (23) provides a correction function g(t) as a function of time t independent of the sweep velocity $v_s$ of the spectrum analyser (1) for the convolution of the input signal a(t) pre-filtered in the pre-filter (22; 24, 26).

2. Spectrum analyser according to claim 1,
**characterised in that**
the correction function g(t) is calculated according to the following equation:

$$\mathbf{g(t)} \;=\; e^{j2\pi^* v_s/2^* t^2} \;.$$

3. Spectrum analyser according to claim 1 or 2,
**characterised in that**
the digital-filter component (24) of the pre-filter (22; 24, 26) contains a non-recursive digital filter, which is integrated in the correlator (23).

4. Spectrum analyser according to any one of claims 1 to 3,
**characterised in that**,
the correlator (23) is realised with algorithms for the implementation of the Fast Fourier Transform.

5. Spectrum analyser according to any one of claims 1 to 4,
**characterised in that**
the target-frequency generator (18; 32) is a sawtooth generator, which generates a frequency ramp for controlling the frequency oscillator (21) over the entire frequency range to be measured of the input signal a(t).

6. Spectrum analyser according to claim 5,
**characterised in that**
the spectrum analyser (1) measures the entire frequency range to be measured or measures a partial frequency range of the entire frequency range to be measured of the input signal a(t).

7. Spectrum analyser according to claim 6,
**characterised in that**
the spectrum analyser measures the entire frequency range and/or one or more partial frequency ranges at the same time with a different resolution bandwidth.

8. Spectrum analyser according to any one of claims 1 to 7,
**characterised in that**
the target-frequency generator (18; 32) is realised by a function generator for the generation of a triangular time function (32), of which the ascending and descending frequency ramp provides a different gradient and is used to control the frequency oscillator (21) respectively over the entire frequency range to be measured of the input signal a(t).

**Revendications**

1.  Analyseur de spectre (1), qui travaille selon le principe de chevauchement, avec un générateur de fréquence théorique (18, 32), un oscillateur de fréquence (21) local, un mélangeur (20), un filtre de résolution (2 ; 2' ; 2'' ; 2''' ; 2'''' ; 2''''' ; 2'''''') et un détecteur (13, 14, 15, 16),
    le filtre de résolution (2 ; 2' ; 2'' ; 2''' ; 2'''' ; 2''''' ; 2'''''') comprenant un préfiltre (22 ; 24, 26) et un corrélateur (23) monté en aval,
    le préfiltre (22 ; 24, 26) présentant une dépense impulsionnelle h(t) indépendante de la vitesse de balayage v$_s$ de l'analyseur de spectre (1) en fonction du temps t pour le préfiltrage d'un signal d'entrée a(t) à mesurer avec l'analyseur de spectre (1) et mémorisant les valeurs de balayage c (k) préfiltrées de la fonction d'entrée par a(t) en temps réel dans une mémoire (27) numérique, que le corrélateur (23) émet de façon asynchrone, de sorte que la convolution est effectuée en mode offline complétant dissociée dans le temps du préfiltrage,
    et le corrélateur (23) présentant une fonction de correction g(t) dépendante de la vitesse de balayage v$_s$ de l'analyseur de spectre (1) en fonction du temps t pour la convolution du signal d'entrée a(t) préfiltré dans le préfiltre (22 ; 24, 26).

2.  Analyseur de spectre selon la revendication 1,
    **caractérisé en ce que**
    la fonction de filtre g(t) calcule selon l'équation suivante :

$$g(t) = e^{j2\pi^\varphi v_s / 2^\varphi t^z}$$

    le préfiltre (22 ; 24, 26) comprenant une partie de filtre (24) analogique et une partie de filtre (26) numérique consécutive,

3.  Analyseur de spectre selon la revendication 1 ou 2,
    **caractérisé en ce que**
    la partie de filtrage (24) numérique du préfiltre (22 ; 24, 26) contient un filtre numérique non récursif qui est intégré dans le corrélateur (23).

4.  Analyseur de spectre selon l'une quelconque des revendications 1 à 3,
    **caractérisé en ce que**
    le corrélateur (23) est réalisé avec des algorithmes pour la mise en oeuvre de la transformation de Fast-Fourier.

5.  Analyseur de spectre selon l'une quelconque des revendications 1 à 4,
    **caractérisé en ce que**
    le générateur de fréquence théorique (18 ; 32) est un générateur en dents de scie qui génère une rampe de fréquence pour l'activation de l'oscillateur de fréquence (21) sur l'ensemble de la plage de fréquence à mesurer du signal d'entrée a(t).

6.  Analyseur de spectre selon la revendication 5,
    **caractérisé en ce que**
    l'analyseur de spectre (1) mesure l'ensemble de la plage de fréquence à mesurer ou une plage de fréquence partielle de l'ensemble de la plage de fréquence à mesurer du signal d'entrée a(t).

7.  Analyseur de spectre selon la revendication 6,
    **caractérisé en ce que**
    l'analyseur de spectre mesure l'ensemble de la plage de fréquence et/ou une ou plusieurs plages de fréquence partielles simultanément avec une largeur de bande de résolution différente.

8.  Analyseur de spectre selon l'une quelconque des revendications 1 à 7,
    **caractérisé en ce que**
    le générateur de fréquence théorique (18 ; 32) est réalisé par un générateur de fonction pour générer une fonction de temps (32) triangulaire dont la rampe de fréquence croissante et la rampe de fréquence descendante présentent une pente différente, et sert à l'activation de l'oscillateur de fréquence (21) respectivement sur l'ensemble de la plage de fréquence à mesurer du signal d'entrée a(t).

Fig. 1

EP 1 592 131 B1

Fig. 2

Fig. 3

Fig. 4

Fig. 5

Fig. 6

Fig. 7

EP 1 592 131 B1

Fig. 8

HF ZF

ZF

Q

ZF

I

90°

$\sqrt{I^2+Q^2}$

Lin / Log

Peak

Auto Peak

Sample

RMS

20

3

4

8

5

7

9

6

2

10

11

12

13

14

15

16

17

21

32

1

20

EP 1 592 131 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10105258 A1
- US 20030146743 A
- US 6275020 B
- US 5300878 A


**In der Beschreibung aufgeführte Nicht-Patentliteratur**

- **CHRISTOPH RAUSCHER.** Grundlagen der Spektrumsanalyse. Rohde und Schwarz GmbH & Co, 2000, 19-28
- **CHRISTOPH RAUSCHER.** Grundlagen der Spektrumsanalyse. Rohde und Schwarz GmbH & Co, 2000, 29-32